Europäisches Patentamt

(19) European Patent Office

Office européen des brevets

(11) EP 0 803 894 A1

(12) EUROPEAN PATENT APPLICATION

(43) Date of publication:
29.10.1997 Bulletin 1997/44

(51) Int. Cl.⁶: H01J 37/317, H01J 37/32

(21) Application number: 97103478.0

(22) Date of filing: 03.03.1997

(84) Designated Contracting States:
DE GB

(30) Priority: 22.04.1996 FR 9605005

(71) Applicant:
MOTOROLA SEMICONDUCTEURS S.A.
F-31023 Toulouse Cédex (FR)

(72) Inventors:
• Griot, Denis
31170 Turnefeuille (FR)
• Gay, Henri Claude
31130 Fonsegrives (FR)

• Pages, Irenee
31270 Villeneuve Tolosane (FR)
• Gibert, Pierre
31270 Frusins (FR)
• Lin-Kwang, Jacques
31100 Toulouse (FR)

(74) Representative: Gibson, Sarah Jane et al
Motorola,
European Intellectual Property Operations,
Midpoint,
Alencon Link
Basingstoke, Hampshire RG21 7PL (GB)

(54) **Combined ion beam and microwave irradiation means and method**

(57) An apparatus (10) is described for implanting ions (18) into a substrate (14) and annealing implant damage by irradiation with microwaves (26). In a preferred embodiment of the process (60), the microwaves (26) heat (66) the substrate (14) to a predetermined temperature (Tp) before ion implantation begins (68) and are left on (67) during implantation (69). When the desired implant dose has been achieved (70), the ion beam and microwave radiation are turned off (70, 72) at about the same time and the substrate (14) rapidly cooled (74) by radiation to the cold walls of the chamber (12), thereby preventing significant lateral dopant redistribution. The substrate (14) holding chamber (12) and its ion beam port (19) and microwave port (24) are designed to facilitate coupling of microwaves (26) into the substrate (14) and avoid coupling of the microwaves (26) into the ion implanter (16).

FIG.1

EP 0 803 894 A1

Printed by Rank Xerox (UK) Business Services
2.14.18/3.4

## Description

### Field of the Invention

The present invention concerns means and methods for irradiating substrates with a combination of energetic particles and microwaves to alter the properties of the substrates.

### Background of the Invention

It is well known in the electronic art to use ion bombardment and implantation to locally alter the properties of substrates. Ion implantation is widely used with semiconductor substrates to construct transistors, diodes, resistors, capacitors and other types of electronic elements. Sometimes the implanted ions are dopant ions and at other times they can be ions which produce compounds, as for example, producing silicon dioxide in silicon substrates.

One of the consequences of ion implantation is crystalline damage. The higher the implant dose, the greater the damage. It is usually necessary to heat the substrate to anneal the crystalline damage and/or activate the implanted ions (e.g., render them electrically active). As used herein, the word "annealing" is intended to include "activation".

The relationship between implant dose and annealing temperature is complex especially when the implant dose is large enough to produce dislocation loops or to approach the solid solubility limit of the dopant in the substrate or the level needed for creation of a stoichiometric compound with the substrate. Annealing often must be carried out at elevated temperatures and for significant periods of time. It is not unusual with silicon, for example, to anneal at the order of $10^3$ °C for times of the order of $10^2$ to $10^3$ minutes. The duration of implant and annealing steps and the energy required therefore can greatly increase the cost of electronic devices being formed in the substrate. Depending upon the dose, residual implant damage is sometimes very difficult or impossible to anneal using prior art techniques and residual damage can severely degrade device performance. Accordingly a need for improved implant and annealing means and methods continues to exist.

It is known in the art to do annealing by heating in conventional ovens or furnaces and by the use of various visible and infra-red light sources (see for example, S. M. Sze, "Semiconductor Technology", McGraw-Hill, New York, 1985, page 252, Fig. 23) and by application of microwaves (see for example, U. S. Patent 5,284,795 Gay et al., "Thermal Annealing of Semiconductor Devices", filed December 9, 1991 based on French Patent 9016040 filed December 20, 1990). However, these prior art methods suffer from a number of disadvantages or limitations which are familiar to those of skill in the art. Hence there continues to be a need for improved implant and annealing means and methods.

## BRIEF DESCRIPTION OF THE DRAWINGS

FIG. 1 is a simplified schematic diagram of a combined ion implant and microwave heating apparatus according to a preferred embodiment of the present invention;
FIG. 2 is a simplified diagram of a portion of the apparatus of FIG. 1 showing additional details of the substrate target chamber;
FIG. 3 is a simplified schematic diagram similar to FIG. 1 but according to a further embodiment of the present invention;
FIG. 4 is a simplified flow chart of the method of a preferred embodiment of the present invention; and
FIG. 5 is a simplified, exemplary, temperature-time diagram for the process illustrated in FIG. 4.

## DETAILED DESCRIPTION OF THE DRAWINGS

The present invention concerns improved means and methods for altering the properties of substrates by microwave irradiation of the substrates during ion implantation. For convenience of explanation and not intended to be limiting, the invented means and method is described by way of example in connection with ion implantation into semiconductor substrates to locally alter their electrical and other properties. It is especially useful in connection with semiconductor substrates, as for example, silicon but is not limited merely to silicon or to other semiconductor substrates. Further, the present invention is applicable to complex or multilayered or multi-material substrates as well as homogeneous substrates and to polycrystalline as well as single crystalline substrates and combinations thereof.

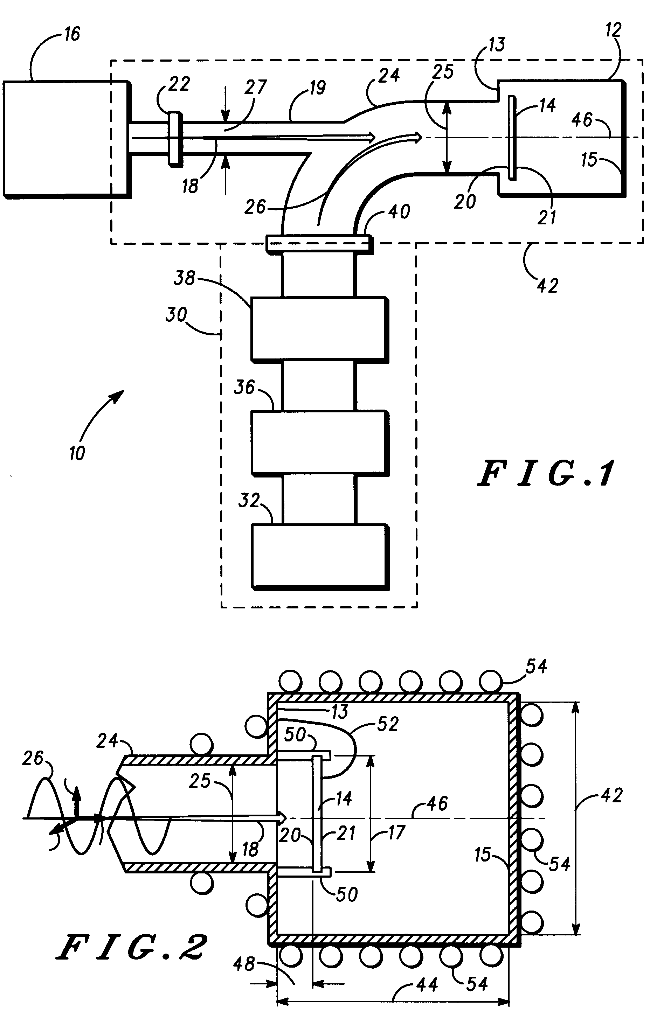

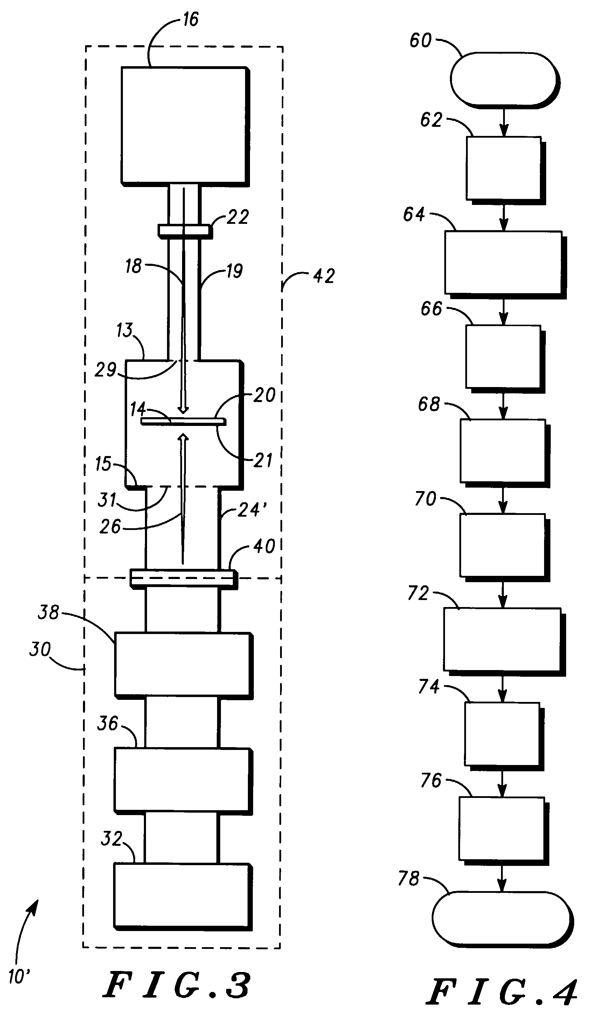

FIG. 1 shows a simplified schematic diagram of combined ion implant and microwave heating apparatus 10 according to a preferred embodiment of the present invention. FIG. 2 shows further details of sample chamber 12 holding substrate 14 and FIG. 3 illustrates a further embodiment of the invention. In FIGS. 1-3, the same reference numbers are used to identify analogous elements.

Referring now to FIGS. 1-2, apparatus 10 comprises sample chamber 12 containing substrate 14. For convenience of explanation and not intended to be limiting, substrate 14 is a conventional single crystal silicon wafer of diameter 17 of about 100 mm and of about 0.5 mm thickness, although this is not essential. Any suitable substrate can be used and of larger or smaller size, depending upon the desires of the user.

Ion implanter 16 directs ion beam 18 through coupling section 19 against front face 20 of substrate 14. Ion implanter 16 can be a flood or scanning ion implanter. In the tests performed, a medium current scanning implanter (Eaton Model NV-3206) was found to be convenient. It provided an approximately cylindrical beam of, e.g., boron, oxygen, etc. ions, with a diameter of about 7-8 mm and a beam current of about 50-500 microamps at an acceleration potential of about 30-150 kV. However, any suitable implanter can be used provided that it is capable of the beam currents, accelerating potential and ion types desired for the particular application. Beam current monitor 22 is conveniently provided for determining the ion beam current and total dose being supplied by implanter 16.

Waveguide section 24 is conveniently coupled to front face 13 of sample chamber 12 so as to direct microwave radiation 26 against front face 20 of wafer 14. As persons of skill in the art will understand based on the description herein, microwaves 26 can propagate into chamber 26 through and around substrate 14 and therefore surround substrate 14 and penetrate therein. A quarter circle was conveniently used for Waveguide section 24 to facilitate coupling of ion beam 18 into chamber 12.

Waveguide section 24 is coupled to microwave generator 30 which delivers microwaves 26 to waveguide section 24 and wafer 14. Microwave generator 30 conveniently comprises, microwave source 32, power measuring section 36 for detecting at least the reflected power Pr assuming the input power Pi is known or, alternatively, detecting both Pi and Pr so that the net power Pn = Pi - Pr transferred to wafer 14 is known or can be determined.

Power measuring section 36 is conveniently coupled to matching section 38 which provides for impedance matching of the generator and load. The various individual components and connecting waveguides that make up microwave generator 30 are conventional and commercially available. A microwave source able to provide several kilowatts of power at one half to several gigahertz is suitable. For example, a magnetron providing about 2 kW at about 2.45 gigahertz was used, but higher and lower frequencies and higher and lower powers can also be used. It is desirable to use frequencies which couple efficiently to sample chamber 12 and wafer 14.

Vacuum seal 40, e.g., a quartz window, is provided to separate microwave generator 30 from vacuum section 42 within which lies ion beam 18 and substrate 14. In this manner, microwave generator 30 need not be made air-tight nor operate under vacuum conditions. Vacuum section 42 need only include those portions of apparatus 10 for whose operation vacuum conditions are needed. This is generally limited to those portions of apparatus 10 involving ion beam 18. Sample chamber 12 is conveniently included within vacuum portion 42. It is desirable that coupling section 19 through which ion beam 18 passes, have lateral dimensions 27 that are below cut-off frequency $f_{co}$ for propagation of the microwaves being employed so that, as far as section 19 does not significantly affect the microwave field at wafer 14 or permit significant amounts of microwave energy to be reflected back into ion implanter 16. This is a particular feature of the present invention. Coupling section 19 can have a circular or rectangular or other cross section as suits the needs of the user and the particular implanter or other parts of the system whose operation would be perturbed by microwaves 26.

Sample chamber 12 can be circular or rectangular in cross-section and designed to support various microwave propagation modes, as for example but not limited to, the $TE_{01}$, $TE_{10}$ or $TE_{11}$ propagation modes. A circular chamber was found to be convenient with diameter 42 of about 120 mm and length 44 of about 40-60 mm, but other dimensions can also be used, provided that they facilitate mounting substrate 14 and coupling microwave energy thereto. Standing waves will generally exist within chamber 12 which can act as a microwave cavity.

Waveguide section 24 of lateral dimensions 25 can be circular or rectangular or any other convenient shape and can have a uniform or tapered cross-section. A rectangular cross-section is convenient. It is important to provide appropriate microwave coupling to sample chamber 12 so that the maximum energy can be transferred to substrate 14. The exact shape and size of waveguide section 24 will depend upon the microwave frequency, the shape of sample chamber 12, the manner of coupling chosen by the user and the microwave propagation modes being excited within sample chamber 12. For example, waveguide section 24 conveniently has a rectangular cross-section with lateral dimensions of about 4.3 x 8.7 cm for operation at about 2.45 gigahertz.

Substrate 14 is conveniently mounted with its principal front face 20 perpendicular to axis 46 of chamber 12 and axially centred therein. Wafer 14 is conveniently supported by, for example, three or more dielectric posts 50 or other support means. It is desirable that the posts or other support means provide thermal isolation from the conductive walls of cavity 12 and not significantly perturb the microwave energy being coupled to wafer 14 so as to avoid adverse affect on the uniformity of wafer heating (where uniformity is desired). In order to prevent perturbation of ion beam 18 due to charging, electrically conductive lead 52 is provided to bleed off any accumulated charge to the walls of cavity 12 or other reference potential. Lead 52 is desirably of a material able to withstand high temperatures.

Front face 20 of wafer 14 is conveniently located distance 48 from front face 13 of chamber 12. Distance 48 of 2-4 mm was found to be convenient, but larger or smaller distances can be used provided that substrate 14 is located in a region of relatively large microwave field strength. It is desirable that the microwave field strength be laterally uniform over the portion of the substrate desired to be heated.

It is preferable that the orientation of the electromagnetic waves relative to substrate 14 (see FIG. 1) be such that the Poynting Vector $\underline{P}$ expressing the direction of microwave power flow (i.e. $\underline{P} = \underline{E} \times \underline{H}$) is oriented along axis 46 of cavity chamber 12 and perpendicular to face 20 of substrate 14. The electric field vector $\underline{E}$ and magnetic field vector $\underline{H}$ lie parallel to the plane of wafer face 20, but this is not essential. It is desirable that substrate 14 be located within chamber 12 at a maximum of a standing wave pattern of the microwave radiation 26 or at least at a location that provides significant field strength in the plane of the wafer. The polarisation of microwaves 26 approaching and within sample chamber 12 can be rectangular or circular or elliptical. While sample chamber 12 can be designed to support different microwave propagation modes, it is desirable to choose modes that provide the most uniform microwave energy distribution in the location of substrate 14 and across diameter 17 of substrate 14 when uniform heating is desired.

Cooling coils 54 are desirably provided to maintain the walls of sample chamber 12 at a low temperature relative to substrate 14. Water or other fluid can be circulated through coils 54 for this purpose. Keeping the walls of sample chamber 12 at a comparatively low temperature is desirable to avoid out-gassing or sublimation of contaminants from the walls of chamber 12 and to provide a heat sink to facilitate rapid radiative cooling of substrate 14 after microwaves 26 are turned off. In the experiments carried out, sample chamber 12 was a copper alloy, but pure copper or aluminium or aluminium alloys or other relatively good conductors can also be used. While coils 54 and water are convenient for cooling sample chamber 12, other heat removal arrangements well known in the art can also be used. For example, and not intended to be limiting, chamber 12 can be double walled with a cooling fluid (liquid or gaseous) circulating in channels between the outer and inner walls, or sample chamber 12 can be finned and cooled by passing a gas or liquid over the fins, or combinations of tubes, channels and/or fins can be used.

Waveguide 24 can also be coupled to other faces of sample chamber 12 instead of or in addition to face 13. For example, in apparatus 10' of FIG. 3, microwaves 26 are directed through rear face 15 of chamber 12, so that the Poynting Vector P points toward rear face 21 of wafer 14. In FIG. 3, waveguide section 24' is straight rather than curved as in FIG. 1, but this is not essential and any means for introducing the microwave radiation will suffice. The front or rear faces of chamber 12 are not the only alternatives for introducing microwave radiation 26. It can be coupled into chamber 12 by any convenient arrangement, e.g., via the front face, rear face, one or more side faces or a combination thereof. Further, slots or gratings or other coupling apertures or antennas can be used to enhance the distribution of microwave energy within sample chamber 12 and its coupling to substrate 14. What is important is that the microwave energy be efficiently coupled to substrate 14 and with reasonable spatial uniformity so that the relevant portion of substrate 14 is heated as uniformly as is desired. Also, ion beam portion 19 can have aperture 29 to help prevent propagation of microwaves 26 back toward implanter 16, provided that aperture 29 does not interfere with scanning beam 18 (from a scanning implanter).

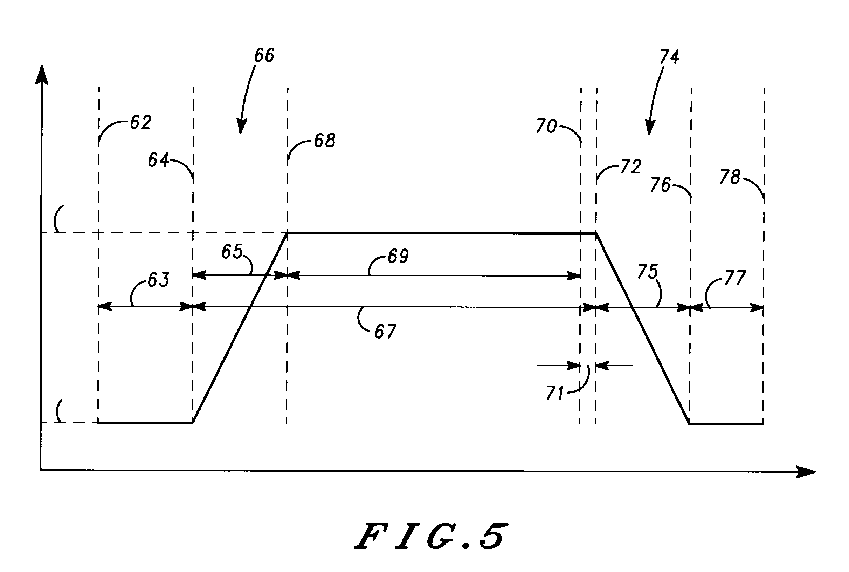

FIG. 4 illustrates a simplified flow diagram of an implant-microwave implant and anneal treatment process 60, according to the present invention and FIG. 5 is an example of a temperature-time diagram for the process of FIG. 4. For convenience of explanation, it is assumed that substrate 14 is silicon. Process 60 comprises step 62 wherein wafer 14 is loaded into chamber 12 ready for processing. Step 62 has duration 63 of about 10-20 seconds. Then in step 64, microwave source 30 is turned-on to flood wafer 14 with microwaves 26. Step 64 causes the temperature of wafer 14 to rise (step 66) to predetermined temperature Tp, for example, in the range for silicon substrates of 600-1300 °C and more conveniently 900-1200 °C and typically about 1000 °C, but other temperatures are also useful. Persons of skill in the art will understand based on the teachings herein that different substrate materials will require different values of Tp.

Wafer heating or "ramp-up" step 66 has duration 65. Duration 65 depends upon the microwave power level applied. Sufficient power should be applied to heat substrate 14 to Tp within about 60 seconds, preferably within about 30 seconds and preferably about 10 seconds or less. Wafer heating to temperatures of the order of 1000 °C can be provided in times of 10 seconds or less because of the high rate of energy transfer to silicon wafer 14 from microwaves 26 and the thermal isolation of wafer 14 within evacuated sample chamber 12. For silicon wafers commonly used for deice fabrication, it was found that this could be accomplished with microwave power levels of about 20 Watts/cm$^2$.

When wafer 14 reaches predetermined temperature Tp, implanter 16 is turned on in step 68 to direct ions 18 to wafer 14. With the medium current implanter used, beam 18 scans across wafer 14 at about 4000/100 (x/y) times per second. Implant duration 69 depends upon the current capabilities of implanter 18 and the dose to be implanted to produce the desired change in substrate properties chosen by the user. Implant duration 69 varies but times of 50-120 seconds are typical for providing useful levels of dopant implants (e.g., $10^{15}$ - $10^{16}$ ions/cm$^2$) in silicon for transistor or other device formation with a medium current implanter. Longer or shorter times can be used, depending upon the background wafer doping level and the implant impurity doping level desired by the user and the current capabilities of the implanter. For example, where buried dielectric layers are being created in a semiconductor substrate, implant times of the order of 3600 seconds may be needed depending upon the current capabilities of the implanter, i.e., how long it takes the implanter to deliver ~$10^{18}$ ions/cm$^2$.

After implant duration 69 is complete, implanter 16 is turned off in step 70, that is, ion beam 18 is removed from wafer 14. Step 72 (microwaves off) is desirably carried our within time lag 71 of step 70. Step 72 can be carried out by turning off microwave source 30 or merely diverting microwaves 26 from chamber 12. Time lag 71 can be either positive (microwaves off after ion beam off), negative (microwaves off before ion beam off) or about zero (microwaves and ion beam shut off at about the same time). In general, it is desirable that time lag 71 be about zero or positive, that is, that $t_{72} \geq t_{70}$, where t is time and $t_{jk}$ indicates the time at which step "jk" is carried out. While step 72 (microwaves off) can occur before step 70 (implant off), i.e., time lag 71 is negative, this is less desirable because the probability that there will be residual implant damage that is not annealed increases unless the substrate location being implanted is maintained at or near Tp.

The magnitude of time lag 71 (either positive or negative) is usefully $\leq 20\%$ of duration 69, more desirably $\leq 10\%$, still better $\leq 5\%$ and preferably $\leq 2\text{-}3\%$ of duration 69. For negative lag 71 (microwaves off first), the smaller the magnitude of lag 71, the less risk of residual implant damage. For positive lag 71 (ion beam off first), the smaller the magnitude of lag 71, the less the risk of significant dopant redistribution. It was found that time lags 71 in the range of plus or minus 0-10 seconds were useful, more conveniently 0-5 seconds, and preferably 0-3 seconds.

The microwaves can be left on for an extended periods of time after the implant is stopped. This has the effect of maintaining the wafer at an elevated temperature after the dopant ions have been placed within the wafer. This is useful where very heavy doses of chemical reactants are being implanted to form, for example, buried oxide or nitride layers. In such cases the implant dose must exceed the solid solubility limit for such ions in order to the form a stoichiometric oxide or nitride or other compound.

In cooling step 74 of duration 75, the temperature of wafer 14 rapidly ramps-down to approximately room temperature, or at least a temperature low enough so that further diffusion of the implanted ions has effectively ceased and the substrate can be safely brought out into an atmosphere (step 76). Cooling is conveniently accomplished by radiative cooling from wafer 14 to the cooled walls of sample chamber 12. However, the wafer can also be flooded with a relatively inert gas (i.e., a gas that does not produce undesirable chemical reactions with the substrate at these temperatures) to provide convective and conductive cooling to further accelerate the cooling process. After step 76 the wafer is transferred to the next step in the overall device fabrication process as indicated at 78. Cool-down duration 75 from Tp of about 1000 °C is about 10 seconds and removal duration 77 is about 10 seconds.

The total time required to process a wafer utilizing the above noted process is about 110-170 seconds depending upon the implant dose provided. In n-type silicon of 0.1-8 ohm-cm conductivity, a boron dose corresponding to about $10^{15}$ ions/cm2 provides a junction depth of about 1-3 microns and a dose corresponding to about $10^{16}$ ions/cm2 provides a junction depth of about 3-6 microns.

The times required to perform the concurrent implant+microwave heating process of the present invention can be compared with a conventional sequential implant + anneal process. The times to load the implanter, perform the implant and unload the implanter are about the same for the two processes and therefore do not affect the comparison. In the invented process, the annealing is carried out during the implant step so no additional anneal step or time is needed. Hence only the temperature ramp-up (step 66 = heat wafer) and ramp-down (step 74 = cool wafer) times remain to be compared between the invented and conventional processes.

With the invented process, heating and cooling steps 66 and 74 of durations 65 and 75 respectively, take about 10+10 = 20 seconds total for each wafer, assuming that one wafer at a time is being processed. There is no further anneal time to be added with the invented process since annealing takes place concurrently with the implantation. Typical furnace anneals are carried out on 200 wafers in a batch. Typical ramp-up + anneal + ramp down times for a conventional prior art process are 40+120+60 = 220 min. = 13200 sec. Dividing by the batch size gives a time of about 13200/200 = 66 seconds per wafer. Thus, there is a net savings of about 66-20 = 46 seconds per wafer.

Since many millions of wafers are manufactured per year, the total time and cost that can be saved is substantial. Further, there is a substantial saving in energy since it is not necessary to heat the large apparatus associate with a thermal furnace, which is usually left running continuously whether in use for annealing or not. There is also a saving compared to heating by quartz lamps which due to the higher absorption of their chambers are also less efficient. Thus, the invented process is substantially more efficient and has desirable time saving and cost advantages over prior art techniques.

It was found that where it is desired to form buried dielectric layers by, for example, implanting oxygen or nitrogen, a two stage implant is very useful. For example, a silicon substrate was first implanted for about 10 minutes to a dose of about $0.6 \times 10^{18}$ $O^+/cm^2$, with the average wafer temperature reaching about 600-650 °C due to the implant beam alone. This was followed by a second stage of about 20 minutes at the same beam current ($\sim 12$ milliamps) where the oxygen ion dose was increased to about $1.8 \times 10^{18}$ $O^+/cm^2$ while the microwaves were applied at about 40 Watts/cm² to raise the substrate temperature in the scanned region to about 1000 °C during the implant. Higher or lower temperatures can also be used, but it is desirable that the first stage implant be done at less than about 800 °C and the second stage implant be done at more than about 900 °C, preferably $\geq 1000$ °C. The above-described two-stage process provides a buried oxide layer of stoichiometric $SiO_2$ about 0.4 micrometers thick approximately 0.2-0.25 micrometers below the substrate surface with the intervening silicon being of good crystalline quality. The results are comparable to or better than those obtained by implanting to about $1.1 \times 10^{18}$ $O^+/cm^2$ followed by a six hour furnace anneal at 1200-1300 °C using the conventional prior art process. Thus, buried dielectric layers as well as doped regions can be obtained using the invented process.

It has been further discovered that the invented process does not produce significant redistribution of previously formed doped regions. This is because the time at high temperature with the invented process is generally several orders of magnitude less than the annealing times for prior art sequential implant + anneal processes. This is of great practical utility since it simplified both device and process design. Otherwise, in the prior art, each new implant + anneal step causes the previously formed junctions to move and these complex changes had to be taken into account. The present process avoids or minimises such complexity and is extremely useful.

It has been further discovered that there is a cooperative effect in the substrate between implanting ions and the microwaves that accelerates implant damage annealing beyond what is accounted for based on the wafer temperature alone and which inhibits lateral diffusion of the implanted dopant. As the ions decelerate through collisions within the substrate, additional free carriers are produced which locally enhance the absorption of microwave energy in a small region of the substrate just underneath the impinging ion beam. These extra carriers absorb energy from the microwaves. This additional energy is partly coupled back to the crystal lattice thereby enhancing the relaxation of crystal defects induced by the decelerating ions. This goes on simultaneously with defect formation so that few if any defects become frozen in when the implant is done. It is believed that the "effective temperature" of the crystal lattice is higher immediately under the implanting ion beam than it would otherwise be due to the impinging ions alone, even taking into account the elevated temperature of the substrate as a whole and the energy being deposited by the ions themselves. This effect is transient, that is, it moves along with the moving ion beam. Because of this cooperative interaction, annealing or removal of implant damage is able to take place at a much higher rate in the immediate vicinity of the implant beam than would be expected merely on the basis of the average wafer temperature. Hence, virtually complete annealing of implant damage can be achieved in seconds while the implant is occurring as opposed to hours of post implant annealing using prior art techniques. This is a particular feature of the present invention that has great practical utility.

A further feature of this cooperative effect is that it leads to highly asymmetric redistribution of the implanted dopant. Specifically, there is much less lateral (parallel to the wafer surface) dopant redistribution than vertical (perpendicular to the wafer surface) dopant redistribution during the implant. For example, a concurrent boron implant and microwave anneal carried out at 920 °C for 720 seconds to a dose of $3x10^{16}$ ions/cm$^2$ in a 1-17 ohm-cm n-type silicon wafer, produced a junction depth of 3.8 micrometers and a lateral diffusion under the edge of the masking oxide of only 0.82 micrometers.

This is a vertical to lateral diffusion ratio of almost 5 to 1, as compared to a ratio of about 10 to 9 typically observed with a conventional, sequential implant + anneal.

Thus, the invented process is capable of providing substantial vertical/lateral junction depth asymmetry in ion implanted junctions, where significant asymmetry is intended to mean at least 2/1. Depending upon the dose and other conditions, asymmetry can be 3/1, still better 4/1 and as high as 5/1. This is a further feature of the present invention that is of great practical significance because it permits one to make smaller devices occupying less area even when comparatively deep junctions are desired. This permits the packing density of integrated circuits to be increased and more complex integrated circuits to be fabricated.

By shutting off the microwaves at about the same time as the implant, the doping asymmetry provided by the present invention is generally preserved. Even after several minutes of continued (post-implant) microwave exposure, conventional lateral dopant redistribution is minimal. The total time is too short for significant dopant movement at the temperatures of interest. Not only do the junctions produced using the invented process have little side diffusion, but this asymmetry can be preserved through subsequent ion implantations carried out using the present invention.

While the present invention has been illustrated by means of particular apparatus, and by implanting and heating of certain types of substrates, persons of skill in the art will understand based on the description herein that the invented process is broadly applicable to many different types of implant ions and substrates and to the formation of many different types of electronic structures. Further, while particular combinations of microwave components and implanters and target chambers have been described, these are not intended to be limiting and other arrangements for concurrently providing energetic ions and microwaves to a common region of the substrate, can be used. It is important that the ion beam current and microwaves power level be such that there is a constructive interaction with the microwaves taking place in the substrate in the small region where the ions are decelerating and causing crystalline damage, so as to raise the effective local temperature while the ion beam is present in that location, so that implant damage annealing is concurrently healed without need for significant post-implant annealing. It is intended that these and other variations as will occur to those of skill in the art, be included in the scope of claims that follow.

**Claims**

1. An apparatus for implanting ions in a substrate, comprising, a source of microwaves of frequency f directed toward the substrate in a first direction through a first coupling region, and a source of energetic ions directed toward the substrate in a second direction through a second coupling region having a cut-off frequency $f_{co}$ for propagation of microwaves, wherein $f_{co} < f$.

2. The apparatus of claim 1 wherein the first and second directions are such that the microwaves are directed toward a common surface of the substrate.

3. The apparatus of claim 1 wherein the first and second directions are such that the microwaves are directed toward opposed surfaces of the substrate.

4. The apparatus of claim 1, 2 or 3 wherein the substrate is contained within a chamber within which the microwaves provide standing waves.

5. The apparatus of claim 1, 2, 3 or 4 wherein the substrate is contained within a chamber whose walls are cooled.

6. The apparatus of claim 1, 2, 3, 4 or 5 wherein there is provided a vacuum chamber for containing the substrate and into which the microwaves and ions are directed and wherein the substrate is supported within the chamber by a thermally non-conductive support member.

7. The apparatus of claim 6 further comprising an electrical lead coupling the substrate to a reference potential to prevent charging of the substrate.

8. The apparatus of any preceding claim wherein the microwaves comprise $TE_{01}$, $TE_{10}$ or $TE_{11}$ propagation modes or combinations thereof.

9. The apparatus of any preceding claim wherein there is provided a vacuum tight window separating the source of microwaves and the substrate.

10. A method of introducing selected ions into a substrate comprising:

    exposing the substrate to microwaves to heat it to a predetermined temperature;
    then impinging the selected ions on a surface of the substrate while the substrate is exposed to the microwaves until a predetermined implantation dose has been reached; and
    shutting off the selected ions and the microwaves sufficiently coincident in time so as to preserve a substantially asymmetric distribution of the selected ions within the substrate.

11. The method of claim 10 wherein after shutting off the microwaves, the substrate is radiatively cooled.

12. The method of claim 10 or 11 wherein a time difference between shutting off the microwaves and shutting off the selected ions is equal or less than about 20% of a duration of the step of impinging the selected ions.

13. The method of claim 10, 11 or 12 wherein sufficient microwave energy is supplied to heat the substrate to the predetermined temperature in less than 60 seconds.

14. The method of claim 10, 11, 12, or 13 wherein the step of impinging the selected ions includes impinging the selected ions on a first face of the substrate and the step of impinging the microwaves includes impinging them on the same face of the substrate.

15. The method of claim 10, 11, 12 or 13 wherein the step of impinging the selected ions includes impinging the selected ions on a first face of the substrate and the step of impinging the microwaves includes impinging them on another face of the substrate.

*FIG.1*

*FIG.2*

*F I G . 3*

*F I G . 4*

*F I G . 5*

EP 0 803 894 A1

**European Patent Office**

# EUROPEAN SEARCH REPORT

Application Number

EP 97 10 3478

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,Y | FR 2 670 950 A (MOTOROLA SEMICONDUCTEURS SA) 26 June 1992 | 1,3 | H01J37/317 H01J37/32 |
| A | * abstract * * page 1, line 30 - page 2, line 13; figure 1 * | 10 | |
| Y | WO 95 31034 A (PHILIPS ELECTRONICS NV ;PHILIPS NORDEN AB (SE)) 16 November 1995 * page 5, line 10 - line 25; figure 3 * | 1,3 | |

TECHNICAL FIELDS SEARCHED (Int.Cl.6)

H01J

The present search report has been drawn up for all claims

| Place of search | Date of completion of the search | Examiner |
|---|---|---|
| THE HAGUE | 30 July 1997 | Schaub, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document